# EUROPEAN PATENT APPLICATION

(11) **EP 3 684 153 A1**
(43) Date of publication of application: **22.07.2020**
(21) Application number: 19152491.7
(22) Date of filing: 18.01.2019
(51) Int. Cl.: H05K 7/20

(54) **COOLING UNIT**

(71) Applicant: Asetek Danmark A/S, 9220 Aalborg East (DK)
(72) Inventor: Schaltz, Torben Søgaard, 9500 Hobro (DK); Saksager, Anders Hjørringgaard, 9210 Aalborg SØ (DK)
(74) Representative: Chas. Hude A/S

(57) **Abstract**

The invention relates to a cooling unit (100) and use thereof for cooling liquid in a liquid-cooled computer system (1), wherein the cooling unit (100) comprises: an air cooling unit (139) for generating an airflow in a first direction; a radiator (111) having a liquid transportation path comprising channels (115) through which said liquid can be conducted and where said airflow can pass between said channels (115) to exchange heat between liquid in said channels (115) and said airflow; characterised in that said cooling unit (100) further comprises a radiator chamber (119) with an intake end (110) and an exhaust end (112), said ends located opposite from one another along said first direction, the radiator chamber (119) further having a top (114) and a bottom (116); said air cooling unit (139) being positioned at said intake end (110) of said radiator chamber (119) to generate an airflow in said first direction into said radiator chamber (119), and said radiator (111) being arranged in the radiator chamber (119) and extending between said intake end (110) and said exhaust end (112), and from said top (114) to said bottom (116), the radiator being arranged at an incline or a decline relative to said first direction. Thereby, a compact cooling unit is provided that fits into existing form factors and is cost effective both in construction and use while providing significant heat dissipation.

## Description

### FIELD OF THE INVENTION

The invention relates to cooling units and use thereof for cooling computing units.

### BACKGROUND OF THE INVENTION

Computer and server systems generate heat. Large server facilities use a substantial amount of energy on cooling for vital electronic parts to ensure smooth operation and long lifetimes of parts. A server facility has a number of server cabinets, each having a number of computing unit racks. In water-cooled systems, each computing unit rack has a cooling loop for cooling the computing units generating the most heat, traditionally any of memory, CPUs and/or GPUs.

For integrated, pre-planned water-cooled facilities, each individual rack-mounted computing unit has a cooling loop. These cooling loops are connected to a central water distribution board on the server cabinet. The cabinet can have a heat exchanger coupled with a secondary facility level water system that moves the now heated facility water to a cold environment, such as outside the facility, and moves the cooled cabinet system water back to the rack loop. This approach allows efficient cooling that displaces the heat to outside the facility immediately.

For small systems, rack level stand-alone loops are implemented that circulate the water and cool it on a per-rack basis. The water loop circulates the heated water from the computing units to an in-rack radiator, where air cooling is used to displace the heat into the facility air. Once there, the computer room air conditioning unit (CRAC) handles it.

However, cooling each rack with its own stand-alone water cooling loop may not be possible or feasible due to space utilisation in the rack. Also, it may be impossible or unfeasible to route water systems on a facility level, especially where the server facility is not converted entirely to water cooling.

### SUMMARY OF THE INVENTION

It is the aim of the current invention to alleviate at least some of the above-mentioned problems. This is achieved by providing a cooling unit and use thereof for cooling liquid in a liquid-cooled computer system. The cooling unit comprises an air cooling unit for generating an airflow in a first direction and a radiator having a liquid transportation path comprising channels through which said liquid can be conducted and where said airflow can pass between said channels to exchange heat between liquid in said channels and said airflow.

The cooling unit is characterised in that the cooling unit further has a radiator chamber with an intake end and an exhaust end, the ends located opposite from one another in said first direction, and the radiator chamber further having a top and a bottom, and in that the air cooling unit is positioned at the intake end of the radiator chamber to generate an airflow in said first direction into said radiator chamber, and further in that the radiator is arranged in the radiator chamber and extends between the intake end and the exhaust end, and from said top to said bottom, and in that the radiator is arranged at an incline or a decline relative to said first direction.

Thereby, a compact cooling unit is provided that fits into existing form factors and is cost effective both in construction and use while providing significant heat dissipation.

Since the radiator extends from the top and one end of the radiator chamber to the bottom and the other end of the radiator chamber, the radiator runs essentially diagonal to the radiator chamber. This allows a long radiator with a large number of channels. By implication of the geometry of the radiator and the radiator chamber, the pressure loss over the radiator is furthermore minimal which allows a low energy use for the air cooling unit.

The air-cooling unit can comprise any airflow-producing devices, such as axial fans or centrifugal fans. In an embodiment, fans optimised for high airflow are used. Thereby, a high air flow is generated. In an embodiment, fans optimised for high pressure are used. Thereby, a high pressure differential over the radiator is ensured. Conveniently, a row of high-power axial fans are used.

The radiator is made substantially of conductive material such as copper and/or aluminium. In an embodiment, the radiator comprises fins between its channels. This maintains airflow while providing a larger heat dissipation surface.

The radiator chamber is the volume of the cooling unit, where the airflow from the air cooling unit meets the tilted radiator, and where the most significant heat exchange occurs. When viewed from the side, the radiator extends substantially diagonally through the radiator chamber from one corner to the opposite corner. The radiator may not meet the corners exactly, such as for practical reasons. A flow guide may be located at the intake end, and necessary liquid conducting tubes may for example also restrict sizing. However, the radiator is arranged in a way where at least a significant portion of the airflow generated by the air cooling unit is forced to traverse the radiator by passing between the channels of the radiator in order to leave the cooling unit.

In an embodiment, the radiator is at an incline relative to the first direction. By being at an incline relative to the first direction, the radiator extends from the lowermost corner at the intake end to the uppermost corner at the exhaust end. By providing the radiator at an incline, an effective radiator is achieved.

In an embodiment, the radiator is at a decline relative to the first direction. By being at a decline relative to the first direction, the radiator extends from the uppermost corner at the intake end to the lowermost corner at the exhaust end. By being at a decline, when the air is heated by the radiator, the air expands and gravity assists in the transfer to the exhaust side of the radiator, since the air has to pass upwards to pass between the channels of the radiator.

In an embodiment, the liquid transportation path is at least substantially filled with cooling liquid. Thereby, the efficiency of the cooling unit and proper functioning of the radiator is ensured.

In an embodiment, the liquid transportation path provides fluid communication from said liquid inlet through said channels and to the liquid outlet. Thereby, an integrated water loop is ensured to achieve a simple construction and a small footprint which allows the available space to be used for the radiator chamber and the radiator.

In an embodiment, a plane parallel to the bottom surface of the radiator chamber and abutting a bottom surface of said inlet opening intersects said radiator. Thereby, gravity ensures that at least some of the channels of the radiator are filled with water.

In an embodiment, the length of the radiator chamber is greater than its width. Thereby, the invention is used to provide efficient cooling with a compact form factor that has been conventionally difficult to use for cooling, such as liquid cooling.

In an embodiment, the width of the radiator chamber is greater than its height. Thereby, the invention is used to provide efficient cooling with a compact form factor that has been conventionally difficult to use for cooling, such as liquid cooling.

In an embodiment, the channels have oblong cross-sectional areas perpendicular to the extension of said radiator.

Thereby, conventional radiator designs can be used thus making production cheap and easy while providing efficient cooling.

By being oblong, the cross-sectional area can take any geometrical two-dimensional form, where one of its dimensions is longer than its other dimension. Preferably, a rectangle or a rectangle with rounded corners can be used. Ovals and other polygonal shapes are also possible.

By the extension of the radiator is meant its angle within the radiator chamber that is essentially diagonal.

In an embodiment, the channels have oblong cross-sectional areas oriented parallel to the first direction.

Thereby, the airflow from the air cooling unit has minimal resistance as it passes through the radiator since it does not require a change of direction to do so. This further increases performance thus making operations cheap and easy and providing efficient cooling.

In an embodiment, the channels have oblong cross-sectional areas angled within the acute angle defined between perpendicular to the extension of the radiator and parallel to the first direction.

Thereby, the airflow from the air cooling unit travelling in the first direction has little resistance as it passes through the radiator. This further increases performance, making operations cheap and easy and providing efficient cooling.

In an embodiment, the radiator comprises two sets of channels traversing the radiator chamber. The liquid transportation path conducts the liquid through a first set of channels and subsequently through a second set of channels, where the first set of channels is arranged between the air cooling unit and the second set of channels. Thereby, improved cooling performance is achieved since a stepwise pseudo-counterflow structure is used. In an embodiment, more than two sets of channels are used. The first passing through the radiator chamber is farthest from the air cooling unit and each subsequent set of channels is closer to the air cooling unit. The last set of channels, through which the liquid passes, is the set closest to the air cooling unit. This allows efficient stepwise pseudo-counterflow cooling.

In an embodiment, the cooling unit is adapted to fit into a server cabinet and to fill a number of rack slots in the server cabinet, preferably two rack slots. Thereby, unused space is utilised in the server facility instead of using server facility footprint like walking area. This further allows easy maintenance and modular use, where computing units, which need to be water-cooled, can be moved to the server cabinet and plugged to the cooling unit for enhanced cooling.

In an embodiment, the radiator chamber further comprises at least one flow adjuster which changes the flow between the air cooling unit and the radiator. Thereby, the airflow is controlled in a better way before it traverses the radiator thus increasing performance and reducing cost. This can be especially helpful for acute angle cooling units, because the air has to change direction significantly to pass through the radiator as well as because acute angle cooling units are often acute because they are low. Cooling units with narrow height dimensions have smaller air cooling units thus having to work at higher speeds. This further increases the value of flow adjustment to even out the flow before the radiator. Flow adjusters can be sheets arranged from side to side between the air cooling unit and the radiator. Their cross section can be of different shapes depending on the particular need. One beneficial layout is to have a flow adjuster at an incline from the air cooling unit if the radiator is at a decline, and at a decline if the radiator is at an incline. In other words, the flow adjuster preferably 'points' at the radiator. This ensures at least that an amount of air is pressed against the nearest part of the radiator instead of all the air being pushed against the farthest parts of the radiator. Furthermore, it may help redirect the flow to align with the gaps between the channels of the radiator.

The flow adjuster can take various shapes. It can be a straight sheet which is preferably angled relative to the radiator. In an embodiment, the flow adjuster is curved between the first direction being the direction of the airflow as it leaves the air cooling unit, and a second direction being more closely aligned with the angle of the gaps between the radiator channels. Thereby, the airflow direction is changed incrementally along the flow adjuster and its alignment with the radiator channel gaps is improved, when it approaches the radiator.

In an embodiment, the flow adjuster is droplet-shaped. Thereby, the pressure in the radiator chamber is effectively manipulated.

In an embodiment, at least two flow adjusters are present in the radiator chamber.

In an embodiment, pressure adjusters modify the flow between the radiator and the exhaust end of the radiator chamber. By modifying the flow between the radiator and the exhaust end of the radiator, the air may flow away more quickly thus decreasing the pressure on the exhaust side of the radiator. This increases the pressure differential over the radiator and then increases radiator performance.

In an embodiment, the cooling unit comprises a water reservoir with an opening for filling new water into the water stream. In an embodiment, the water reservoir is provided in conjunction with the combining manifold. In an embodiment, the water reservoir is provided in conjunction with the dividing manifold. Thereby, a compact radiator is provided which utilises the space of its given sizing constraints effectively. Furthermore, a simple and compact design is ensured that allows easier and better fitting of parts in the computing racks for computing parts while also not taking up space outside the server cabinet.

In an embodiment of the invention, it relates to a computer cooling system having a cooling unit according to the invention. Thereby, the cooling unit provides cooling to a computing system for improved computing performance.

In an embodiment of the invention, it relates to a server cabinet having a computer cooling system with a cooling unit according to the invention. Thereby, the cooling unit provides cooling to a server facility for improved computing performance.

In an aspect, the invention relates to using a cooling unit according to the invention for cooling liquid in a liquid cooled computer system.

Thereby, a compact cooling method is provided that works with existing form factors and is cost effective to use while providing significant heat dissipation.

Since the radiator is provided from the top and from one end of the radiator chamber to the bottom and to the other end of the radiator chamber, the radiator runs essentially diagonal to the radiator chamber. This allows a long radiator with a large number of channels. By implication of the geometry of the radiator and the radiator chamber, the pressure loss over the radiator is furthermore minimal which provides a good flow rate and/or allows a low energy use for the air cooling unit.

### LIST OF THE DRAWINGS

In the following, example embodiments are described according to the invention, where
Fig. 1 is an axonometric view of a server cabinet with a cooling unit according to the invention,
Fig. 2A is an axonometric top front view of a cooling unit according to the invention,
Fig. 2B is an axonometric top rear view of a cooling unit according to the invention,
Fig. 3A is a top view of a cooling unit according to the invention,
Fig. 3B is another top view of the cooling unit according to the invention,
Figs. 4A-4D are cross-sectional side views of different embodiments of the cooling unit 100 according to the invention, and
Figs. 5A-E are cross-sectional side views of cooling units having flow adjusters according to the invention.

### DESCRIPTION OF THE DRAWINGS

In the following, the invention is described in detail through embodiments thereof that should not be thought of as limiting to the scope of the invention.

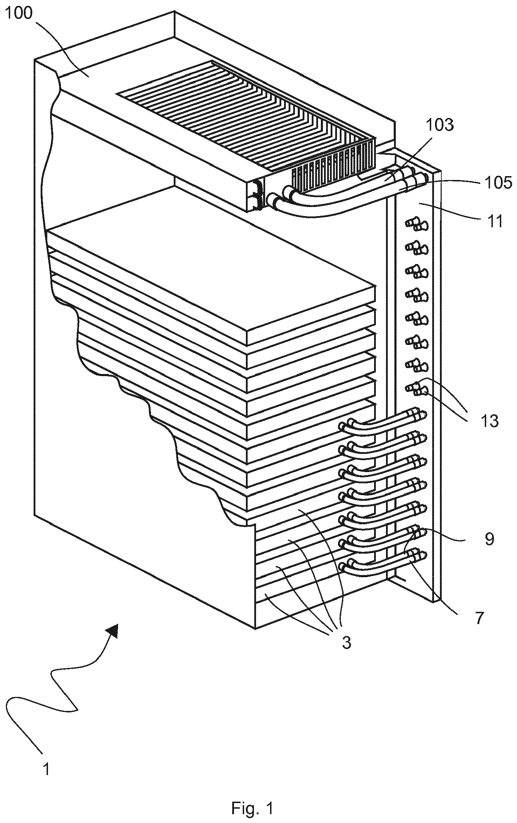

Fig. 1 is a server cabinet 1 with a number of racks 3, each of which can hold a computing unit conventionally with at least one CPU, memory cards and optionally one or more GPUs depending on the computing and/or storage services provided.

The cabinet further has a water hub 11 to distribute coolant/water to the individual computing racks 3 to provide cooling. Water is routed to the computing units through inlet tubes 7, courses through a water loop, which cools the computing unit, and travels back to the water hub 11 through an outlet tube 9. The inlet tube 7 and outlet tube 9 are attached reversibly to the water hub 11 by way of attachment valves 13 for ease of installation and maintenance.

The uppermost rack slots of the server cabinet 1 are taken up by a cooling unit 100. The cooling unit 100 has an inlet channel 103 and an outlet channel 105 attaching its liquid system to the water hub 11 of the server cabinet 1. Water from the water hub 11 enters the cooling unit 100 by the cooling inlet 103 and returns by the cooling outlet 105 after being cooled.

Thereby, a liquid cooling solution is achieved that can cool multiple computing units, such as all computing units in the racks 3 of a server cabinet 1. In Fig. 1, the bottom seven racks are water-cooled using the cooling unit 100 of the invention. The top five racks are air-cooled conventionally and may be switched to water cooling at any time by simply changing the air cooling units for water cooling loops and attaching them to the water hub 11 through the attachment valves 13. No additional footprint in the server facility is required, and no part of the cooling system has to be placed beside or on top of the server cabinet 1. By slotting directly into the existing rack interface, the cooling rack 100 is easy to install and manage for server technicians. Furthermore, more room is provided in the individual racks 3 for each computing unit as air cooling can be omitted or be smaller. This allows computing units initially using air cooling to be modified for water cooling, when economics or convenience demands. This in turn allows either cheaper parts or better performing parts. It becomes easy to install and maintain a few water-cooled computing unit racks 3 in an otherwise air-cooled server cabinet or server facility. It is also easy to install or upgrade to a full server cabinet 1 of water-cooled computing units later. Thereby, an intermediate step between individual rack 3 water cooling and server facility-wide water cooling implementation is obtained that scales significantly and is modular.

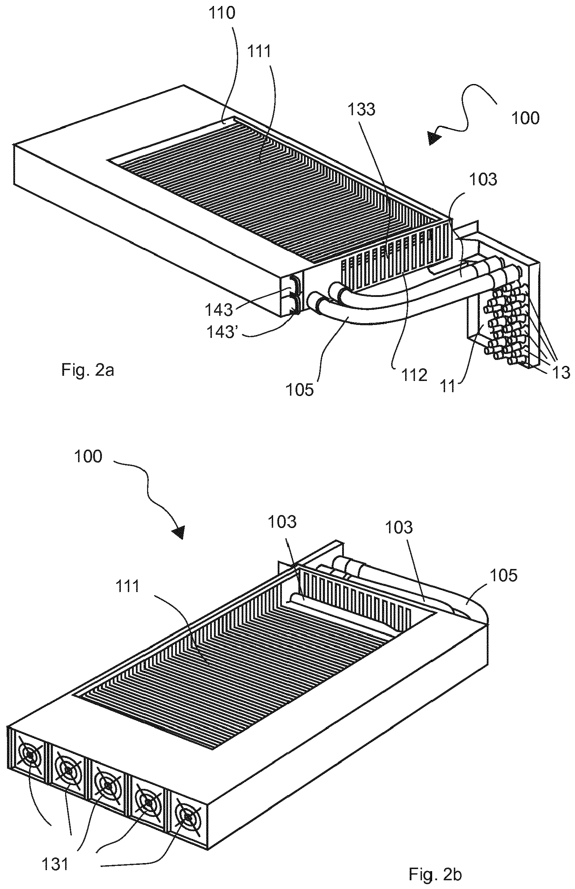

Figs. 2A and 2B are isometric top views of the cooling unit 100 according to the invention. Fig. 2A shows the cooling unit 100 attached to a water hub 11 through an inlet channel 103 and an outlet channel 105 for water transport. The water hub is a compact version with the attachment valves 13 clustered close to the cooling unit 100. The cooling unit 100 has a sloped radiator 111 which will be described in further detail later. The radiator 111 slopes in a radiator chamber from an inlet end 110 to an exhaust end 112. Air passes through the sloped radiator 111 to an air outlet 133 in the exhaust end 112 being a perforated end plate allowing hot air to be transported away from the cooling unit 100. In the figure, the radiator chamber is shown with an open top, which eases air transport after air passes the radiator. In another embodiment, a closed top is used which improves air flow control and increases thermal dissipation. In an embodiment, a hexagonal 'honey-comb' grid pattern is used for the air outlet 133. In an embodiment, elongated perforations are used.

A primary power supply unit 143 transforms power and provides the needed voltage and amperage for the electronic parts of the cooling unit 100. This powers an air cooling unit (not shown) and fan controllers (not shown). An auxiliary power supply unit 143' ensures improved operational stability by being a failsafe to improve cooling unit 100 uptime.

Fig. 2B shows the cooling unit 100 with an inlet channel 103, outlet channel 105 and a sloped radiator 111. Air inlets 131 allow cool air to be drawn into the cooling unit 100 by air cooling unit (not shown).

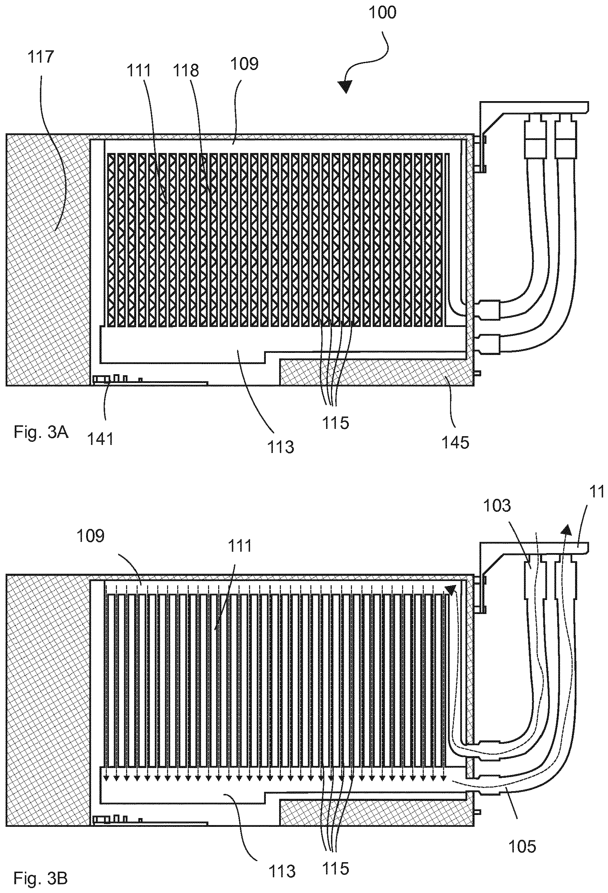

Fig. 3A is a top view of the cooling unit 100. The cooling unit 100 has a dividing manifold 109, a combining manifold 113 and a sloped radiator 111. The radiator 111 has channels 115 and heat fins 118. A fan compartment 117 holds the air cooling unit (not shown) of the cooling unit 100, and a controller unit 141 controls the air cooling unit to provide the airflow to cool the sloped radiator 111. The controller unit 141 controls the fan speed according to predetermined settings such as radiator temperature thus processing unit temperature or dividing manifold 109 water temperature. A power supply compartment 145 holds the power supply unit(s) of the cooling unit 100.

Fig. 3B is a top view of the cooling unit 100 illustrating the water flow through the cooling unit 100. Water enters the cooling unit 100 through the inlet channel 103 from the distribution hub 11. It is led first to the dividing manifold 109. It is then led through the individual channels 115 of the sloped radiator 111 to a combining manifold 113. From the combining manifold 113, the now cooled water returns by the outlet channel 105 to the distribution hub 11 to cool the computing units.

The manifolds are dimensioned to allow adequate flow distribution among the channels 115 of the radiator. The combining manifold 113 acts conveniently as water reservoir. Thereby, the system can sustain evaporative losses without affecting the function of the cooling solution.

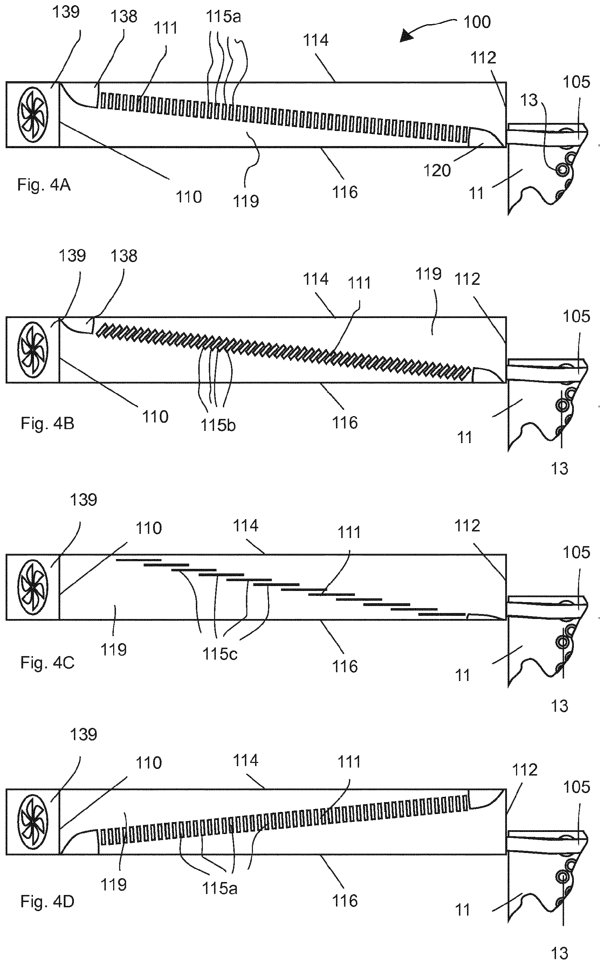

Figs. 4A-D are cross-sectional side views of different embodiments of the cooling unit 100 according to the invention. A sloped radiator 111 is provided in a radiator chamber 119 that is elongated. The radiator chamber 119 has an intake end 110, where an airflow produced by the air cooling unit 139 enters the radiator chamber 119, and an exhaust end 112, where the airflow leaves the radiator chamber 119. The radiator chamber further has a closed top 114 surface and a closed bottom 116 surface. This is shown in the Figs. 1-3. The sloped radiator 111 is provided at a decline relative to the first direction being the direction of air flow provided by the air cooling unit 139. The water hub is seen in Figs. 4A-C as well.

By providing a sloped radiator 111, the air, which is pushed through the air cooling unit 139, is forced into contact with, and through the radiator 111. Since the surface area of contact under/before the radiator 111 is large, a high degree of heat transfer is ensured. After the air cooling unit 139, a flow guide 138 redirects the air past the thickness of the slanted radiator 111 to aid air distribution across the radiator 111 and to minimise pressure drop and increase the efficiency of the cooling unit 100. The curved surface ensures that the flow has been straightened out by the time it arrives at the channels 115 of the slanted radiator 111.

As the travel distance through the radiator itself is relatively short, there is only a slight pressure drop over the radiator 111, which in turn allows a low fan speed or a higher performance. The design works not least because an overpressure is achieved between the air cooling unit 139 and the radiator 111, and the air is drawn through the radiator 111 to the low-pressure side.

In Fig. 4A, the radiator 111 has perpendicular channels 115a being perpendicular to the extension of the radiator. This is a practical radiator design because it is easy to manufacture and relies on the pressure drop over the perpendicular channels 115a for its air transport. Another unique advantage of this design is the high water throughput combined with the low fin depth. In other words, the combined cross-sectional area of the perpendicular channels 115a is high while the airflow travel distance over the radiator is low thus maintaining the aforementioned low pressure drop. With a low air travel distance, the cooling gradient is further improved as the air in contact with the radiator at any given moment is cool. An air blocker 120 is provided to ensure that the airflow travels through the radiator 111 on its way through the radiator chamber 119.

Fig. 4B illustrates an embodiment of the invention with tilted channels 115b, but is otherwise identical to the embodiment of Fig. 4A. The tilted channels 115b are counter-tilted relative to the radiator slope to ensure that only little drag is created around the sloped radiator 111. Furthermore, it retains a short fin depth whereby air travel distance over the radiator is short thus improving heat dissipation through an improved thermal gradient. The sum of the cross-sectional areas of the channels remains high to ensure a high heat dissipation.

The angle can be any angle between perpendicular to the radiator and parallel to the first direction being the direction of airflow produced by the air cooling unit 139.

Fig. 4C illustrates an embodiment of the invention with fully counter-slanted channels 115c, but is otherwise identical to the embodiment of Fig. 4A. The counter-slanted channels 115c are angled fully counter to the angle of the radiator 111. This creates a situation, where there is substantially free passage through the radiator in the first direction being the flow direction produced by the air cooling unit 139. This ensures a minimal pressure drop and keeps the airflow streamlined around the radiator which improves the heat gradient and improves heat dissipation.

Fig. 4D illustrates an embodiment of a radiator 111 being arranged at an incline relative to the first direction. This embodiment works similarly to embodiments with a radiator arranged at a decline. In embodiments with a radiator arranged at an incline, it is the bottom 116 of the radiator chamber 119 optionally being an open surface as the bottom surface is located 'downstream' from the radiator 111. However, it is preferable to provide it as a closed surface to increase the flow along the last portion of the radiator. A radiator at an incline is naturally fully compatible with any channel designs useful for sloped radiators in the radiator chamber, where it is preferable to select one of those discussed in relation to a declining radiator in Figs. 4A-C. Where the channels 115 are slanted, they should relate the slant to the incline of the radiator.

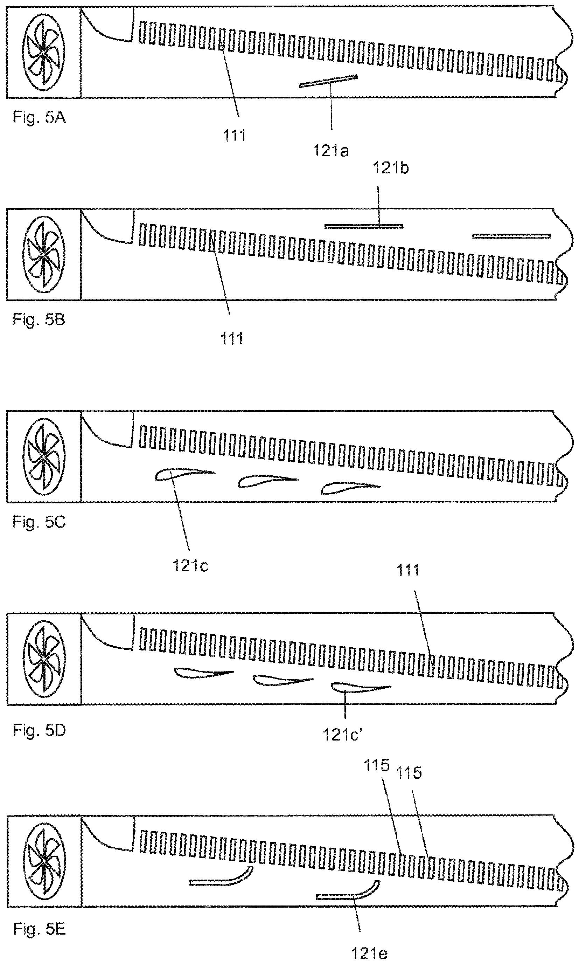

Figs. 5A-C are cross-sectional side views illustrating partial cut-out portions of the sloped radiator 111 of the cooling unit 100 and further with flow adjusters 121.

Fig. 5A illustrates an embodiment of the invention with linear flow adjusters 121 a. These help distribute the air from the air cooling unit 139 over the sloped radiator 111. This can increase flow speed over the radiator 111 and thereby enhance cooling. It is advantageous for the linear flow adjuster 121a to be oriented at an angle towards the radiator 111 such that the airflow is redirected. In another embodiment, the linear flow adjuster 121a is parallel to the first direction being the direction of flow produced by the air cooling unit 139. In an embodiment, there can be more than one linear flow adjuster 121a.

Fig. 5B illustrates an embodiment of the invention with pressure adjusters 121b located between the radiator 111 and the exhaust end 112. By providing pressure adjusters 121b 'down-stream' of the radiator 111, air transport out of the radiator chamber is improved. By improving the flow rate after the radiator, the pressure after the radiator 111 drops thus increasing the pressure differential over the radiator and thus improving flow speed. This can improve radiator cooling or decrease the fan speed for similar cooling.

Fig. 5C illustrates an embodiment of the invention with constriction flow adjusters 121c placed between the air cooling unit 139 and the sloped radiator 111. Constriction flow adjusters 121c work by increasing flow rate close to the radiator 111.

Fig. 5D illustrates an embodiment of the invention with a different type of constriction flow adjusters 121c' located between the air cooling unit 139 and the radiator 111.

Fig. 5E illustrates an embodiment of the invention with lead-in flow adjusters 121e which change the direction of the incoming cool air to align it with the radiator channel 115 angle. This guides the air to the surface of the radiator which reduces drag and improves heat exchange by getting the heated air away from the radiator.

## Claims

1. A cooling unit (100) for cooling liquid in a liquid cooled computer system (1), wherein the cooling unit (100) comprises
- an air cooling unit (139) for generating an airflow in a first direction,
- a radiator (111) having a liquid transportation path comprising channels (115) through which said liquid can be conducted and where said airflow can pass between said channels (115) to exchange heat between liquid in said channels (115) and said airflow,
**characterised in that**
- said cooling unit (100) further comprises a radiator chamber (119) with an intake end (110) and an exhaust end (112), said ends located opposite from one another along said first direction, the radiator chamber (119) further having a top (114) and a bottom (116), where
- said air cooling unit (139) is positioned at said intake end (110) of said radiator chamber (119) to generate an airflow in said first direction into said radiator chamber (119), and where
- said radiator (111) is arranged in the radiator chamber (119) and extends between said intake end (110) and said exhaust end (112), and from said top (114) to said bottom (116), the radiator being arranged at an incline or a decline relative to said first direction.

2. A cooling unit (100) according to claim 1, wherein the length of the radiator chamber (119) is greater than the width of said radiator chamber (119).

3. A cooling unit (100) according to any of claims 1-2, wherein the width of the radiator chamber (119) is greater than the height of said radiator chamber (119).

4. A cooling unit (100) according to any of claims 1-3, wherein the channels (115) have oblong cross-sectional areas perpendicular to the extension of said radiator (111).

5. A cooling unit (100) according to any of claims 1-4, wherein said radiator (111) comprises two sets of channels (115) traversing the radiator chamber (119), where the liquid transportation path conducts the liquid through a first set of channels and subsequently through a second set of channels, wherein said first set of channels is arranged between said air cooling unit and said second set of channels.

6. A cooling unit (100) according to any of claims 1-5, wherein the cooling unit is adapted to fit into a server cabinet and to fill up a number of rack slots in said server cabinet, preferably two rack slots.

7. A cooling unit (100) according to any of claims 1-6, wherein the radiator chamber further comprises at least one flow adjuster to change the flow produced by the air cooling unit between the air cooling unit and the radiator.

8. A computer cooling system having a cooling unit (100) according to claim 1.

9. A server cabinet (1) having a computer cooling system with a cooling unit (100) according to claim 1.

10. Use of a cooling unit (100) according to claim 1 for cooling liquid in a liquid-cooled computer system.
